# EUROPEAN PATENT APPLICATION

(11) **EP 4 553 522 A1**
(43) Date of publication of application: **14.05.2025**
(21) Application number: 23857673.0
(22) Date of filing: 21.08.2023
(51) Int. Cl.: G01R 31/389, G01R 31/36, G01R 31/367, G01R 27/02

(54) **IMPEDANCE MEASUREMENT APPARATUS AND OPERATING METHOD THEREFOR**

(30) Priority: 24.08.2022 KR 20220106404
(71) Applicant: LG Energy Solution, Ltd., Seoul 07335 (KR)
(72) Inventor: KIM, Ki Hyun, Daejeon 34122 (KR)
(74) Representative: Plasseraud IP
(86) International application number: PCT/KR2023/012342
(87) International publication number: WO 2024/043641

(57) **Abstract**

An impedance measurement apparatus according to an embodiment of the present disclosure includes a plurality of detection modules configured to detect response signals respectively corresponding to a plurality of battery cells and a control module configured to calculate impedances respectively corresponding to the plurality of battery cells based on the response signals, in which each of the plurality of detection modules includes a supply unit configured to supply input power to a corresponding battery cell and a detection unit configured to detect the response signal of the corresponding battery cell to the input power during a detection time, and the control module is further configured to adjust the detection time for the plurality of detection modules.

## Description

### [TECHNICAL FIELD]

### CROSS-REFERENCE TO RELATED APPLICATION

This application claims priority to and the benefit of Korean Patent Application No. 10-2022-0106404 filed in the Korean Intellectual Property Office on August 24, 2022, the entire contents of which are incorporated herein by reference.

### TECHNICAL FIELD

Embodiments disclosed herein relate to an impedance measurement apparatus and an operating method thereof.

### [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. A lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

To analyze a state of a battery and detect operating characteristics of the battery over time, electrochemical impedance spectroscopy may be used. The electrochemical impedance spectroscopy may quickly and accurately detect impedance which is a factor hindering electricity transmission when a chemical reaction occurs at an electrode included in the battery.

The state of the battery may be quickly evaluated by detecting the impedance, and it is possible to inspect battery quality, predict the remaining life, and optimize a charging method corresponding to the state of the battery, based on the evaluation.

### [DISCLOSURE]

### [TECHNICAL PROBLEM]

Embodiments disclosed herein aim to provide a measurement apparatus capable of effectively measuring impedances of a plurality of battery cells, and an operating method thereof.

Embodiments disclosed herein aim to provide a measurement apparatus which separates a signal detection time of a plurality of detection modules included in an impedance measurement apparatus to prevent response signal interference between adjacent detection modules, and an operating method of the measurement apparatus.

Technical problems of the embodiments disclosed herein are not limited to the above-described technical problems, and other unmentioned technical problems would be clearly understood by one of ordinary skill in the art from the following description.

### [TECHNICAL SOLUTION]

An impedance measurement apparatus according to an embodiment of the present disclosure includes a plurality of detection modules configured to detect response signals respectively corresponding to a plurality of battery cells and a control module configured to calculate impedances respectively corresponding to the plurality of battery cells based on the response signals, in which each of the plurality of detection modules includes a supply unit configured to supply input power to a corresponding battery cell and a detection unit configured to detect the response signal of the corresponding battery cell to the input power during a detection time, and the control module is further configured to adjust the detection time for the plurality of detection modules.

According to an embodiment, the control module may be further configured to classify the plurality of detection modules into a plurality of groups.

According to an embodiment, the control module may be further configured to classify the plurality of detection modules into the groups based on an arrangement order.

According to an embodiment, the control module may be further configured to identically set detection times of detection modules belonging to the same group among the plurality of detection modules.

According to an embodiment, the control module may be further configured to sequentially set the detection time for each group.

According to an embodiment, he control module may be further configured to classify two detection modules arranged in contact with each other among the plurality of detection modules into different groups.

According to an embodiment, the control module may be further configured to classify detection modules having the arrangement order that does not affect the response signal among the plurality of detection modules into the same group.

According to an embodiment, the plurality of detection modules may be arranged at preset intervals.

According to an embodiment, the input power may be alternating current power.

An operating method of an impedance measurement apparatus according to another embodiment of the present disclosure includes connecting a plurality of battery cells to a plurality of detection modules, adjusting, by a control module, a detection time for the plurality of detection modules, supplying, by a supply unit, input power to the battery cell during the detection time, detecting, by a detection unit, a response signal of a corresponding battery cell corresponding to the input power during the detection time, and calculating, by the control module, impedances respectively corresponding to the plurality of battery cells based on response signals.

According to an embodiment, the operating method may further include classifying, by the control module, the plurality of detection modules into a plurality of groups.

According to an embodiment, the adjusting of the detection time may include sequentially setting, by the control module, the detection time for each group.

According to an embodiment, the classifying of the detection modules into the plurality of groups may include classifying, by the control module, the detection modules based on an arrangement order of the detection modules.

According to an embodiment, the classifying based on the arrangement order may include classifying two detection modules arranged in contact with each other among the plurality of detection modules into different groups.

According to an embodiment, the classifying based on the arrangement order may include classifying detection modules having the arrangement order that does not affect the response signal among the plurality of detection modules into the same group.

### [ADVANTAGEOUS EFFECTS]

An impedance measurement apparatus and an operating method thereof according to an embodiment disclosed herein may prevent response signal distortion due to adjacent detection modules.

The detection modules included in the impedance measurement apparatus according to an embodiment disclosed herein may be divided into a plurality of groups.

The impedance measurement apparatus according to an embodiment disclosed herein may adjust an impedance detection time for each group and detect a signal with a reduced influence of noise from an adjacent detection module.

Moreover, various effects recognized directly or indirectly from the disclosure may be provided.

### [DESCRIPTION OF DRAWINGS]

FIG. 1 is a block diagram of an impedance measurement apparatus according to an embodiment disclosed herein.
FIG. 2 shows a table in which detection modules according to an embodiment disclosed herein are divided into a plurality of groups.
FIG. 3 is a flowchart illustrating an operating method of an impedance measurement apparatus, according to an embodiment disclosed herein.
FIG. 4 is a flowchart illustrating an operating method of an impedance measurement apparatus, according to another embodiment disclosed herein.
FIG. 5 is a block diagram of a hardware configuration of a computing system for performing an operating method of an impedance measurement apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

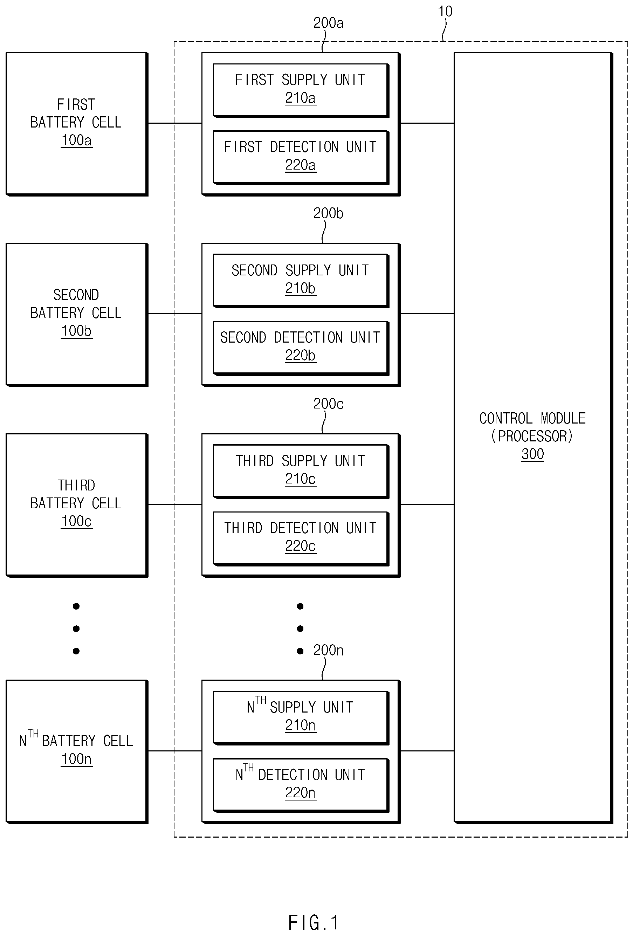

FIG. 1 is a block diagram of an impedance measurement apparatus according to an embodiment disclosed herein.

Referring to FIG. 1, an impedance measurement apparatus 10 according to an embodiment disclosed herein may be connected to a plurality of battery cells 100a, 100b, 100c to 100n. The impedance measurement apparatus 10 may include a plurality of detection modules 200a, 200b, 200c to 200n respectively connected to the battery cells 100a, 100b, 100c to 100n, and a control module 300 that controls the detection modules 200a, 200b, 200c to 200n and calculates impedances respectively corresponding to the battery cells 100a, 100b, 100c to 100n.

According to an embodiment, the number of battery cells 100a to 100n and the number of detection modules 200a to 200n may be set arbitrarily.

The battery cells 100a to 100n may be basic units of a battery including a positive electrode, a negative electrode, a separator, and an electrolyte. The battery cells 100a to 100n may be samples of impedance measurement targets, and the impedance measurement apparatus 10 may include the plurality of detection modules 200a to 200n to measure impedances of a plurality of samples.

The impedance measurement apparatus 10 may include, for example, an electrochemical impedance spectroscopic apparatus. The electrochemical impedance spectroscopic apparatus may measure an alternating current impedance spectrum of a battery cell (e.g., 100a) by using a non-destructive testing method. According to an embodiment, by comparing the measured alternating current impedance spectrum with an equivalent circuit model of a battery cell (e.g., 100a), a deterioration state and performance of the battery cell (e.g., 100a) may be estimated.

The electrochemical impedance spectroscopic apparatus may measure an alternating current impedance spectrum based on a change in amplitude and phase of a response signal detected from the battery cells 100a to 100n with respect to a change in frequency of alternating current (AC) power applied to the battery cells 100a to 100n.

The impedance measurement apparatus 10 may be connected to the battery cells 100a to 100n that are impedance measurement targets through the detection modules 200a to 200n. According to an embodiment, one battery cell (e.g., 100a) may be connected to one detection module (e.g., 200a).

The detection modules 200a to 200n may include a supply unit (e.g., 210a) for supplying power to a battery cell (e.g., 100a) and a detection unit (e.g., 220a) for detecting a response signal of the battery cell (e.g., 100a).

According to an embodiment, the detection modules 200a to 200n may be arranged at preset intervals that may be reduced due to the demand for miniaturization of the impedance measurement apparatus 10.

The supply unit (e.g., 210a) included in each of the detection modules 200a to 200n may supply alternating current power of a preset frequency to the battery cells 100a to 100n respectively connected to the detection modules 200a to 200n. The frequency of the power supplied through supply units 210a to 210n may be set by the control module 300. The control module 300 may set a time when the power is supplied through the supply units 210a to 210n and a time when a response signal is detected corresponding to the supplied power for each of the detection modules 200a to 200n.

According to an embodiment, the supply units 210a to 210n may include a power device capable of changing a frequency and an amplitude of alternating current power.

The detection units 220a to 220n may detect a response signal from the battery cells 100a to 100n respectively connected to the detection modules 200a to 200n and transmit the detected response signal to the control module 300. According to an embodiment, the control module 300 may control the detection units 220a to 220n to operate during a detection time. The detection units 220a to 220n may map the frequency of the alternating current power supplied through the supply units 210a to 210n to the response signal output from the battery cells 100a to 100n and transmit them to the control module 300.

The control module 300 may control the detection modules 200a to 200n to adjust a response signal detection time of the battery cells 100a to 100n, and calculate an impedance corresponding to each of the battery cells 100a to 100n based on the received response signal.

The control module 300 may calculate an impedance based on a frequency of alternating current power input to each battery cell (e.g., 100a) and a response signal output from the battery cell 110a. According to an embodiment, the control module 300 may generate alternating current impedance spectrum of each battery cell (e.g., 110a) based on the calculated alternating current impedance spectrum with an equivalent circuit model of the battery cell (e.g., 100a), thereby estimating a deterioration state and performance of the battery cell (e.g., 100a).

When the supply units (e.g., 210a and 210b) included in adjacent detection modules (e.g., 200a and 200b) supply input power during the same detection time, alternating current power input to the battery cells 100a and 100b may have an influence upon response signals of adjacent battery cells.

More specifically, the first supply unit 210a may supply alternating current power of a preset frequency as input power to the first battery cell 100a, and the second supply unit 210b disposed in contact with the first supply unit 210a may supply alternating current power to the second battery cell 100b while the first detection unit 220a detects a response signal corresponding to the alternating current power.

When the second supply unit 210b supplies alternating current power to the second battery cell 100b, noise may occur in the response signal detected by the first detection unit 220a due to the supplied alternating current power or the response signal output by the second battery cell 100b corresponding to the alternating current power.

When the noise occurs in the response signal, impedances of the battery cells 100a to 100n may be inaccurately calculated, and it may be difficult to diagnose exact states of the battery cells 100a to 100n. In addition, the reliability of the impedance measurement apparatus 10 may not be secured.

For example, to minimize an influence of noise between the adjacent detection modules (e.g., 200a and 200b), positions of the detection modules 200a to 200n may be adjusted. However, to sufficiently secure a separation distance between the adjacent detection modules (e.g., 200a and 200b), a difficulty may occur in miniaturization of the impedance measurement apparatus 10.

According to an embodiment, the control module 300 may classify the plurality of detection modules 200a to 200n into a preset number of groups. The control module 300 may classify the detection modules 200a to 200n based on an arrangement order of the detection modules 200a to 200n, and identically set a time for supplying input power to the detection modules 200a to 200n belonging to the same group and a time for detecting a response signal. The control module 300 may sequentially set an input power supply time and a response signal detection time for each group.

The plurality of detection modules 200a to 200n may be arranged at preset intervals. The control module 300 may classify detection modules of the plurality of detection modules 200a to 200n arranged at preset intervals in which response signal distortion due to noise does not occur even when operating simultaneously into the same group. Thus, mutually contacting detection modules (e.g., 200a and 200b) may be classified into different groups.

According to an embodiment, the control module 300 may supply test power as input power to the battery cells 100a to 100n for group setting. The control module 300 may differentiate a timing in which test power is supplied to each of the battery cells 100a to 100n. The control module 300 may receive a response signal corresponding to the test power and calculate first test impedances respectively corresponding to the battery cells 100a to 100n.

The frequency of the test power may be a preset value, and the test power supplied to the battery cells 100a to 100n may have the same frequency.

The first test impedances may be calculated by independent operation of the detection modules 200a to 200n, and may be values from which noise occurring due to adjacent detection modules (e.g., 200a and 200b) is excluded.

After the first test impedance is calculated, the control module 300 may arbitrarily determine two detection modules for supplying test power to corresponding battery cells from among the detection modules 200a to 200n, based on the arrangement order.

For example, the control module 300 may select the first detection module 200a and the second detection module 200b as detection modules for supplying test power or the first detection module 200a and the third detection module 200c as detection modules for supplying the test power.

The control module 300 may supply the test power to the battery cells (e.g., 100a and 100b) connected to the detection modules (e.g., 200a and 200b) through the two selected detection modules (e.g., 200a and 200b), and detect two response signals corresponding to the test power.

The control module 300 may calculate second test impedances based on the response signals received from the two selected detection modules (e.g., 200a and 200b).

The control module 300 may compare the first test impedance with the second test impedance and determine whether noise occurs. When the first test impedance and the second test impedance are different from each other, the control module 300 may classify the two selected detected modules into different groups. When the first test impedance and the second test impedance are the same as each other or fall within a preset error range, the control module 300 may classify the two selected detected modules into the same group.

The control module 300 may find detection modules that minimize an influence of noise even when input power of the same frequency is supplied to the battery cells at the same timing, through calculation of the first test impedance and the second test impedance.

The control module 300 may classify the detection modules that minimize the influence of noise into the same group, and identically set the detection time, thereby minimizing noise occurring in detection of the impedances of the plurality of battery cells 100a to 100n and reducing a time required for impedance detection.

As the detection modules 200a to 200n are arranged at preset intervals, the control module 300 may classify detection modules with an arrangement order that minimizes noise influence on each other or does not affect the response signal into the same group.

The control module 300 may supply the test power as the input power to the battery cells 100a to 100n to classify the plurality of detection modules 200a and 200b into a plurality of groups, and the number of groups and the number of detection modules belonging to the same group may change with intervals at which the detection modules 200a to 200n are arranged, and distances of the detection modules 200a and 200b which minimize noise occurring in impedance detection.

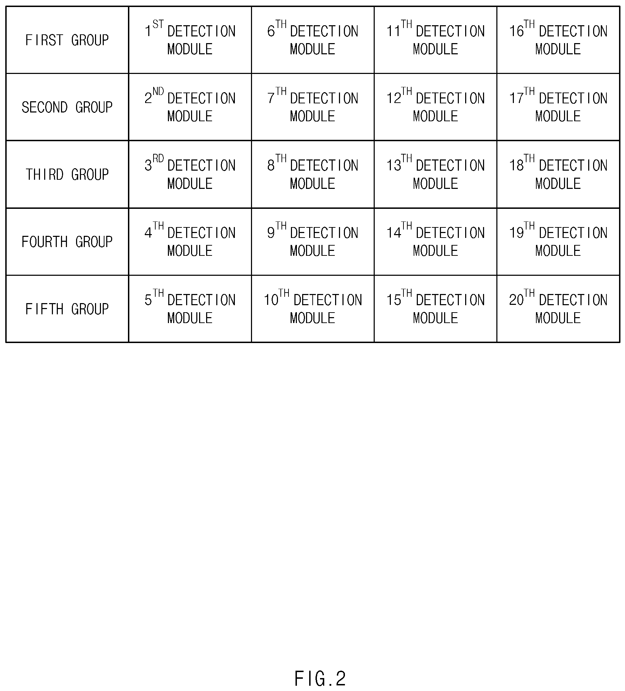

FIG. 2 shows a table in which detection modules according to an embodiment disclosed herein are divided into a plurality of groups.

Referring to FIG. 2, when a total number of detection modules is 20, first to twentieth detection modules may be classified into five groups, each of which includes four detection modules.

For convenience of description, it is assumed that the first to twentieth detection modules may be arranged in a line and arrangement intervals between adjacent detection modules are regular.

The table shown in FIG. 2 may show an embodiment where at least four detection modules need to be arranged between two detection modules to minimize an influence of noise or to avoid affecting response signals.

As described with reference to FIG. 1, a distance that minimizes an influence of noise from an adjacent detection module may be obtained by the control module 300 of FIG. 1 supplying test power as input power to battery cells connected to respective detection modules to calculate the first test impedance and supplying the test power to two arbitrary detection modules among all the detection modules to calculate the second test impedance.

FIG. 2 shows a table where detection modules are spaced apart from each other by 5 or more in an arrangement order to belong to the same group.

The control module 300 of FIG. 1 may identically set the input power supply time and the response signal detection time of the detection modules belonging to the same group. **In** addition, the control module 300 of FIG. 1 may set to sequentially perform input power supply and response signal detection for each group.

According to an embodiment, detection modules (a first detection module, a sixth detection module, an eleventh detection module, and a sixteenth detection module) belonging to the first group may supply input power to corresponding battery cells, and when the response signals of the battery cells are detected, detection modules classified into second to fifth groups may not perform input power supply and response signal detection.

For example, when input power supply and response signal detection of the first group are terminated, input power supply and response signal detection of the second group may be performed. The control module 300 of FIG. 1 may control detection modules to perform input power supply and response signal detection on all the groups (the first to fifth groups), and calculate impedances of all the battery cells based on the detected response signals.

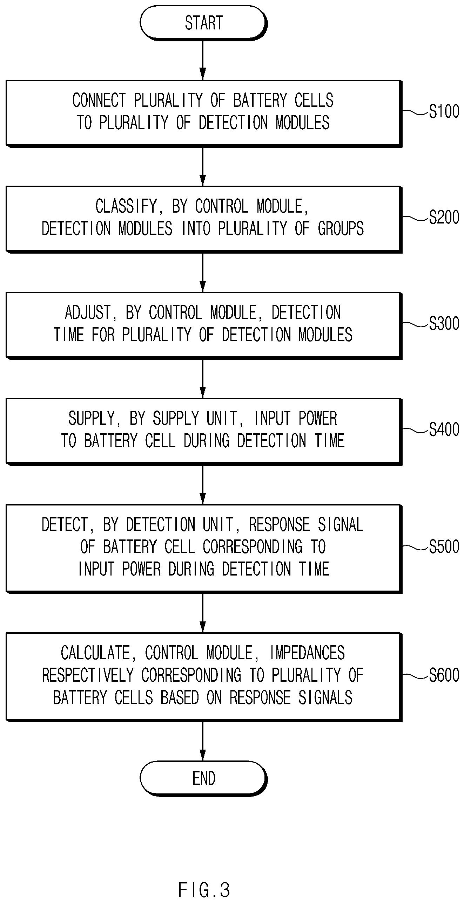

FIG. 3 is a flowchart illustrating an operating method of an impedance measurement apparatus, according to an embodiment disclosed herein.

The plurality of battery cells 100a to 100n may be connected to the impedance measurement apparatus 10, in operation S100.

The battery cells 100a to 100n may be samples that are impedance measurement targets, and the impedance measurement apparatus 10 may include the plurality of detection modules 200a to 200n respectively connected to the plurality of battery cells 100a to 100n.

The control module 300 may classify the plurality of detection modules 200a to 200n into a preset number of groups, in operation S200.

The control module 300 may classify the detection modules 200a to 200n into a plurality of groups based on an arrangement order of the detection modules 200a to 200n. For example, two mutually contacting detection modules (e.g., 200a and 200b) may be classified into different groups.

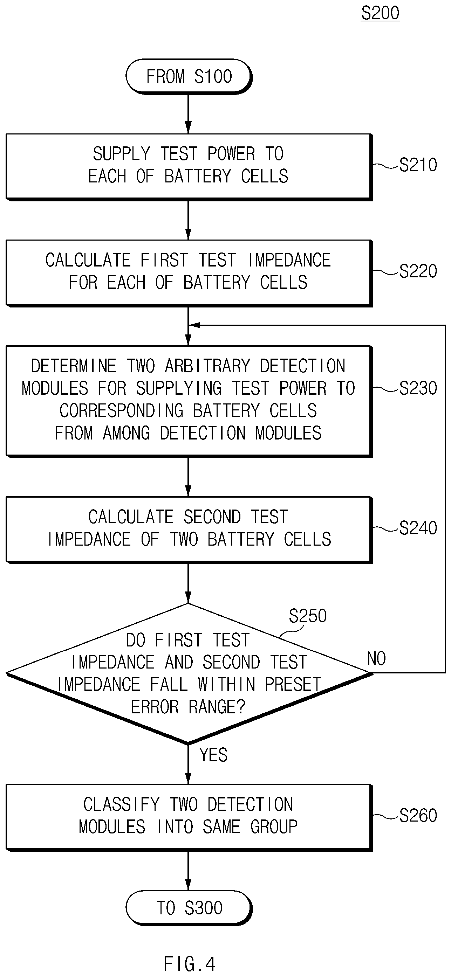

A method for the control module 300 to classify the detection modules 200a to 200n will be described with reference to FIG. 4.

The control module 300 may control a detection time for the plurality of detection modules 200a to 200n, in operation S300. The detection time may refer to a time for detecting a response signal to input power from the battery cells 100a and 100b connected to the detection modules 200a to 200n.

According to an embodiment, the control module 300 may identically set the detection time for the detection modules belonging to the same group.

The control module 300 may sequentially set detection times for respective groups when adjusting the detection times for the plurality of detection modules.

Due to the sequentially set detection time for each group, the detection modules belonging to different groups may not operate at the same timing.

The control module 300 may control a supply unit (e.g., 210a) included in a detection module (e.g., 200a) to supply input power to a battery cell (e.g., 100a) connected to the detection module (e.g., 200a), in operation S400.

The input power may be alternating current power having preset frequency and amplitude.

The detection unit (e.g., 220a) may detect a response signal of the battery cell (e.g., 100a) corresponding to the input power for a detection time in operation S500, and map the frequency of the input power to the response signal to transmit the same to the control module 300.

The control module 300 may calculate impedances respectively corresponding to the plurality of battery cells 100a to 100n based on the response signals, in operation S600.

According to an embodiment, the control module 300 may calculate an impedance for input frequency and generate an alternating current impedance spectrum based on the calculated impedance, for each of the battery cells 100a to 100n. By comparing the generated alternating current impedance spectrum with an equivalent circuit model of the battery cells 100a to 100n, the control module 300 may diagnose a deterioration state and performance of the battery cells 100a to 100n.

FIG. 4 is a flowchart illustrating an operating method of an impedance measurement apparatus, according to another embodiment disclosed herein.

With reference to FIG. 4, a detailed description will be made of a method for the control module 300 to classify the detection modules 200a to 200n into a plurality of groups to prevent noise likely to occur between adjacent detection modules 200a to 200n.

After the plurality of battery cells 100a to 100n are connected to the impedance measurement apparatus 10 in FROM S100, the control module 300 may control the supply units 210a to 210n to supply test power to each of the battery cells 100a to 100n, in operation S210.

The test power may be power having preset frequency.

The test power may be supplied to the battery cells 100a to 100n at different timings.

The control module 300 may receive the response signals of the battery cells 100a to 100n corresponding to the test power from the respective detection modules 200a to 200n.

The control module 300 may calculate first test impedances for the plurality of battery cells 100a to 100n based on the received response signals, in operation S220.

The first test impedances may be calculated based on the response signals detected by operation of the respective detection modules 200a to 200n at different timings, and thus may be values from which an influence of noise between adjacent detection modules (e.g., 200a and 200b) is excluded.

After calculating the first test impedance, the control module 300 may arbitrarily determine two detection modules for supplying test power to corresponding battery cells from among the detection modules 200a to 200n, in operation S230. According to an embodiment, the control module 300 may initially select detection modules that are close to each other, and may select detection modules that are increasingly distant from each other when detection module determination is repeated.

The control module 300 may control the two selected detection modules to supply the test power to the corresponding battery cells through the supply unit. The test power may be simultaneously supplied to the two corresponding battery cells.

The control module 300 may calculate the second test impedances of two battery cells based on the response signals detected through the two detection modules, in operation S240.

The second test impedance may be calculated when the two detection modules operate at the same time, and may be values that reflect an influence of noise upon the two selected detection modules.

The control module 300 may compare the first test impedance with the second test impedance of each battery cell to determine whether they fall within a preset error range, in operation S250. When the first test impedance and the second test impedance fall within the preset error range (YES in operation S250), then the control module 300 may classify the two selected detection modules into the same group in operation S260.

According to an embodiment, when the first test impedance and the second test impedance fall within the preset error range, the control module 300 may use a distance between and an arrangement order of the two selected detection modules to select other detection modules for calculating the second test impedance.

The control module 300 may classify, into the same group, the detection modules 200a to 200n for which the first test impedance and the second test impedance fall within a preset error range and an arrangement order difference between the detection modules is smallest.

After finding out the detection modules for which the first test impedance and the second test impedance fall within the preset error range and an arrangement order difference between the detection modules is smallest, the control module 300 may apply group classification based on the arrangement order between the two detection modules to all the detection modules 200a to 200n to classify the detection modules 200a to 200n.

When the first test impedance and the second test impedance fall out of the preset error range (NO in operation S250), then the control module 300 may determine again the two detection modules for calculating the second test impedance, in operation S230.

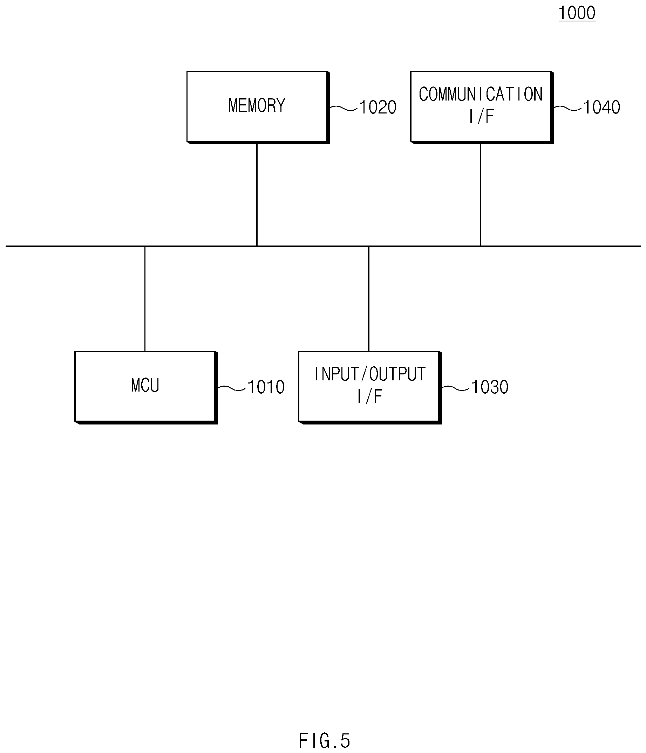

FIG. 5 is a block diagram of a hardware configuration of a computing system for performing an operating method of an impedance measurement apparatus, according to an embodiment disclosed herein.

Referring to FIG. 5, a computing system 1000 according to an embodiment disclosed herein may include a microcontroller unit (MCU) 1010, a memory 1020, an input/output interface (I/F) 1030, and a communication I/F 1040.

According to an embodiment, the computing system 1000 may be a system for performing the above-described operation of the control module 300 or detection module (e.g., 200a).

The MCU 1010 may be a processor that executes various programs stored in the memory 1020.

For example, the MCU 1010 may process voltage, current data, a control signal, etc., required for the control module 300 to manage and control the detection module (e.g., 200a).

The MCU 1010 may be a processor for processing data and/or a signal. For example, the MCU 1010 may adjust current provided to the battery cell (e.g., 100a) to control the detection module (e.g., 200a) to detect a response signal of the battery cell (e.g., 100a). The MCU 1010 may be a processor that performs impedance calculation based on information output from the battery pack 100.

The memory 1020 may store various programs required for the control module 300 to manage and control the battery cell (e.g., 100a) and the detection module (e.g., 200a). The memory 1020 may also store various programs required for the control module 300 to calculate impedance.

For example, the memory 1020 may store a response signal of each battery cell (e.g., 100a) such as voltage, current, feature data, etc. Moreover, the memory 1020 may store a program for calculating an impedance based on a voltage, a current, feature data, etc. The memory 1020 may be provided in plural, depending on a need.

The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, a program or various data, etc., for impedance detection of the battery cell 110 may be transmitted and received to and from a separately provided external server through the communication I/F 1040.

As such, a computer program according to an embodiment disclosed herein may be recorded in the memory 1020 and processed by the MCU 1010, thus being implemented as a module that performs functions shown in FIGS. 1 to 4.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. An impedance measurement apparatus comprising:
a plurality of detection modules configured to detect response signals respectively corresponding to a plurality of battery cells; and
a control module configured to calculate impedances respectively corresponding to the plurality of battery cells based on the response signals,
wherein each of the plurality of detection modules comprises:
a supply unit configured to supply input power to a corresponding battery cell; and
a detection unit configured to detect the response signal of the corresponding battery cell to the input power during a detection time, and
the control module is further configured to adjust the detection time for the plurality of detection modules.

2. The impedance measurement apparatus of claim 1, wherein the control module is further configured to classify the plurality of detection modules into a plurality of groups.

3. The impedance measurement apparatus of claim 2, wherein the control module is further configured to classify the plurality of detection modules into the groups based on an arrangement order.

4. The impedance measurement apparatus of claim 2, wherein the control module is further configured to identically set detection times of detection modules belonging to the same group among the plurality of detection modules.

5. The impedance measurement apparatus of claim 2, wherein the control module is further configured to sequentially set the detection time for each group.

6. The impedance measurement apparatus of claim 3, wherein the control module is further configured to classify two detection modules arranged in contact with each other among the plurality of detection modules into different groups.

7. The impedance measurement apparatus of claim 3, wherein the control module is further configured to classify detection modules having the arrangement order that does not affect the response signal among the plurality of detection modules into the same group.

8. The impedance measurement apparatus of claim 1, wherein the plurality of detection modules are arranged at preset intervals.

9. The impedance measurement apparatus of claim 1, wherein the input power is alternating current power.

10. An operating method of an impedance measurement apparatus, the operating method comprising:
connecting a plurality of battery cells to a plurality of detection modules;
adjusting, by a control module, a detection time for the plurality of detection modules;
supplying, by a supply unit, input power to the battery cell during the detection time;
detecting, by a detection unit, a response signal of a corresponding battery cell corresponding to the input power during the detection time; and
calculating, by the control module, impedances respectively corresponding to the plurality of battery cells based on response signals.

11. The operating method of claim 10, further comprising classifying, by the control module, the plurality of detection modules into a plurality of groups.

12. The operating method of claim 11, wherein the adjusting of the detection time comprises sequentially setting, by the control module, the detection time for each group.

13. The operating method of claim 11, wherein the classifying of the detection modules into the plurality of groups comprises classifying, by the control module, the detection modules based on an arrangement order of the detection modules.

14. The operating method of claim 13, wherein the classifying based on the arrangement order comprises classifying two detection modules arranged in contact with each other among the plurality of detection modules into different groups.

15. The operating method of claim 13, wherein the classifying based on the arrangement order comprises classifying detection modules having the arrangement order that does not affect the response signal among the plurality of detection modules into the same group.
